# EUROPEAN PATENT APPLICATION

(11) **EP 1 811 583 A1**
(43) Date of publication of application: **25.07.2007**
(21) Application number: 06250336.2
(22) Date of filing: 23.01.2006
(51) Int. Cl.: H01L 41/083, H01L 41/047

(54) **Piezoelectric actuator**

(71) Applicant: Delphi Technologies, Inc., Troy, MI 48007 (US)
(72) Inventor: Kolkman, Manfred, Longeau (Messancy), 6780 (BE)
(74) Representative: Caldwell, Judith Margaret

(57) **Abstract**

A piezoelectric actuator comprising a stack (12) of piezoelectric elements (26) formed from a piezoelectric material and a plurality of positive internal electrodes (30) interdigitated with a plurality of negative internal electrodes (32) throughout the stack (12) to define active regions of the piezoelectric material which are responsive to a voltage applied across the positive and negative internal electrodes (30, 32) in use. A positive side electrode (14) connects with the positive internal electrodes (30) and a negative side electrode (16) connects with the negative internal electrodes (32). The actuator is characterised in that the positive and negative side electrodes (14, 16) are formed from a metal and are attached to the stack (12) by an electrically conductive adhesive (18, 20).

## Description

### Field of the Invention

The present invention relates to a piezoelectric actuator, suitable for use in a fuel injector of an internal combustion engine. In particular, the invention relates to the composition and arrangement of the external side electrodes of such an actuator.

### Background Information

A known piezoelectric actuator has a stack structure formed from a plurality of piezoelectric layers or elements substantially separated by a plurality of internal electrodes. The internal electrodes are divided into two groups: a positive group and a negative group. Electrodes of the negative group are interdigitated with electrodes of the positive group. The internal electrodes of the positive group are in electrical connection with an external electrode, hereinafter known as the positive side electrode. Likewise, the internal electrodes of the negative group are in electrical connection with a second side electrode, hereinafter known as the negative side electrode.

If a voltage is applied between the two side electrodes, electric fields arise between the positive and negative internal electrodes that cause each piezoelectric layer, and therefore the piezoelectric stack, to undergo a strain along an axis normal to the plane of each internal electrode. The magnitude and direction of the strain can be reversed by switching the magnitude and/or polarity of the applied voltage. Rapidly varying the magnitude and/or polarity of the applied voltage causes rapid changes in the strength and/or direction of the electric fields across the piezoelectric layers, and consequentially, rapid variations in the length of the piezoelectric actuator. Typically, the piezoelectric stack elements are formed from a ferroelectric material such as lead zirconate titanate.

Each internal electrode of the positive group terminates at a positive face of the stack, and each internal electrode of the negative group terminates at a negative face of the stack. The stack additionally includes metallization layers on the positive and negative faces.

The positive and negative side electrodes are attached to the metallization layers on the positive and negative faces of the stack respectively. Each metallization layer therefore provides an electrical connection between the internal electrodes of a group and the respective positive or negative side electrode. The constraint of the side electrodes by the stack dictates the mechanical demands on the material from which the side electrodes are made. During the lifetime of the actuator, the stack, and therefore each of the side electrodes, undergoes typically 10⁹ cycles of extension and contraction at a strain of approximately 0.2%. Under such conditions, the metallization layers crack and cannot therefore function alone as side electrodes.

In addition, the actuator may typically be required to function at a range of temperatures, typically between -40 and +175 °C, and is subjected to associated thermal mismatch stresses if the piezoelectric material and the side electrode material have dissimilar coefficients of thermal expansion. The side electrode material must carry an average current of typically 3 A rising to 15 A or more under peak current conditions, therefore a high electrical conductivity is required to avoid undesirable resistive heating of the side electrodes.

In addition, in some injector designs, the actuator is contained within a chamber which is filled with fuel under high pressure. The fuel pressure in the chamber varies cyclically in operation between approximately 200 and 2000 bar, and applies a hydrostatic compression to the actuator.

Under such conditions, the side electrodes must remain connected to the internal electrodes and piezoelectric layers and must remain substantially free from fatigue damage such as cracking. Preferably, the stiffness of the side electrodes is low so that any stresses arising from thermal mismatch strains are minimised and so that the force required to extend the side electrodes, which must be generated by the piezoelectric stack, is minimised.

One material known in the art as a side electrode material is silver-loaded epoxy. This material has reasonably high electrical conductivity and low elastic modulus. The side electrodes can be manufactured by coating the piezoelectric stack, where required, with the uncured epoxy. The epoxy must then be cured by heating at a high temperature for a relatively long period of time. This curing step is an inconvenient and costly part of the manufacturing process. In addition, failure of silver-loaded epoxy side electrodes can occur close to the connection between the side electrodes and the terminals, where the current density is highest, as a result of thermal breakdown of the electrode material due to resistive heating. Furthermore, silver can migrate from the electrodes into the piezoelectric material, causing premature failure of the stack.

An alternative known approach provides side electrodes made from Invar (a registered trade mark of Imphy S. A.), which is an alloy having nickel and iron as its major constituents. Invar has a coefficient of thermal expansion of approximately 1.8 x 10⁻⁶ K⁻¹, which is close to that of the piezoelectric stack material. Conventionally, the Invar side electrodes are soldered to the metallization layers, to achieve good electrical contact. However, Invar has poor mechanical properties and can therefore be prone to cracking under the cyclic strain imposed on it by the piezoelectric stack. In addition, soldering requires the use of solder flux, and residues of the solder flux may contaminate the stack.

Use of side electrodes made from metallic materials other than Invar is problematical, since such materials typically have larger coefficients of thermal expansion than the material of the piezoelectric stack. During actuator operation, the mismatch in thermal expansion coefficients generates additional thermal stresses that can cause premature failure of the side electrodes, the stack, or the interface bond between the side electrodes and the stack.

It is one object of the present invention to provide an improved piezoelectric actuator for which the aforementioned disadvantages are alleviated or removed.

### Summary of the Invention

According to a first aspect of the invention, there is provided a piezoelectric actuator comprising a stack of piezoelectric elements formed from a piezoelectric material and a plurality of positive internal electrodes interdigitated with a plurality of negative internal electrodes throughout the stack to define active regions of the piezoelectric material which are responsive to a voltage applied across the positive and negative internal electrodes in use. The actuator further includes a positive side electrode for connection with the positive internal electrodes and a negative side electrode for connection with the negative internal electrodes. The actuator is characterised in that the positive and negative side electrodes are formed from a metal and are attached to the stack by an electrically conductive adhesive.

Advantageously, the electrically conductive adhesive forms a compliant layer of adhesive between the positive side electrodes and the stack and a compliant layer of adhesive between the negative side electrodes and the stack. Elegantly, the electrically conductive adhesive is capable of elastic deformation so as to accommodate differential strains arising between the stack and the positive and negative side electrodes.

The provision of the compliant adhesive layer is particularly advantageous if the side electrodes have a different coefficient of thermal expansion to the piezoelectric stack, since the thermal misfit strains can be substantially accommodated by elastic deformation of the adhesive layers and the electrical contact between the side electrodes and the internal electrodes is maintained. The stresses that would arise in the absence of the compliant adhesive layers are avoided. The choice of electrode material can therefore be made from a wider range of materials than if no adhesive layers were present since the requirement for closely matching the coefficient of thermal expansion of the side electrode material to that of the stack material can be relaxed. Advantageously, the positive and negative side electrodes are formed from an alloy substantially comprising nickel, iron and cobalt.

Preferably, the piezoelectric stack has a positive face carrying a metallization layer on which the positive side electrode is carried and a negative face carrying a metallization layer on which the negative side electrode is carried, so that each adhesive layer is sandwiched between one of the metallization layers and the respective positive or negative side electrode.

Preferably, the piezoelectric actuator further comprises an outer encapsulation means and, advantageously, the positive and negative side electrodes are formed with a smooth outer surface for contact with the outer encapsulation means.

Conveniently, the piezoelectric actuator further comprises a connector module for supplying the voltage across the positive and negative side electrodes when connected with an external voltage supply, in use.

The connector module includes positive and negative terminal conductors, which are bonded to the metallic side electrodes. Current flows through the adhesive layer largely in a direction perpendicular to the plane of the adhesive layer, this direction having the lowest resistance due to its large projected area. Consequentially, high current densities do not arise in the adhesive layer, and thermal breakdown of the adhesive material is avoided since resistive heating is insignificant. In contrast, when previously known conductive polymer-based materials, for example silver loaded epoxy, are used as side electrodes, the current must flow through the polymer parallel to the plane of the side electrodes close to the connection with the terminal conductor. The relevant projected area is much smaller than in the present invention, and therefore the temperature rise due to resistive heating is substantially higher giving rise to the problems of thermal breakdown described above.

The first aspect of the invention also extends to a fuel injector for use in an internal combustion engine, wherein the fuel injector includes a fluid volume for receiving fluid. The piezoelectric actuator as previously described is housed within the fluid volume so that a hydrostatic load is applied by the fluid to the piezoelectric stack. Preferably, the fluid volume is a volume for receiving fuel. Conveniently, the fluid volume forms a part of the flow route for fuel between an injector inlet and an injector outlet to the engine. The actuator is particularly suited to application in an injector including a fuel receiving volume, since the high hydrostatic fuel pressure acting on the actuator acts to push the side electrodes towards the adhesive layers and the piezoelectric stack, thus maintaining good electrical connection between the side electrodes and the internal electrodes.

The first aspect of the invention additionally extends to a first method of forming a piezoelectric actuator comprising a stack of piezoelectric elements formed from a piezoelectric material, a positive side electrode for connection with a plurality of positive internal electrodes and a negative side electrode for connection with a plurality of negative internal electrodes. The method includes providing an adhesive layer comprising a first surface which is exposed and a second surface which is adhered to the one of the positive and negative side electrodes, and applying the exposed, first surface of the adhesive layer to the piezoelectric stack. Optionally, the first surface of the adhesive layer is exposed by removal of a backing layer. The backing layer may be applied to the first surface of the adhesive layer after the second surface of the adhesive layer has been adhered to one of the positive and negative side electrodes. Alternatively, the backing layer may be applied to the first surface of the adhesive layer before the second surface of the adhesive layer has been adhered to one of the positive and negative side electrodes.

The first aspect of the invention also extends to a second method of forming a piezoelectric actuator comprising a stack of piezoelectric elements formed from a piezoelectric material, a positive side electrode for connection with a plurality of positive internal electrodes and a negative side electrode for connection with a plurality of negative internal electrodes. The method includes providing an adhesive layer comprising a first surface which is exposed and a second surface which is adhered to the piezoelectric stack, and applying the exposed, first surface of the adhesive layer to one of the positive and negative side electrodes. Optionally, the first surface of the adhesive layer is exposed by removal of a backing layer. The backing layer may be first applied to the first surface of the adhesive layer when the second surface of the adhesive layer is adhered to the piezoelectric stack. Alternatively, the backing layer may be provided on the first surface of the adhesive layer before the second surface of the adhesive layer is adhered to the piezoelectric stack.

According to a second aspect of the invention, there is provided a piezoelectric actuator comprising a stack of piezoelectric elements formed from a piezoelectric material, a plurality of positive internal electrodes interdigitated with a plurality of negative internal electrodes throughout the stack to define active regions of the piezoelectric material which are responsive to a voltage applied across the positive and negative internal electrodes in use. The actuator further includes a positive side electrode for connection with the positive internal electrodes and a negative side electrode for connection with the negative internal electrodes. The actuator is characterised in that the positive and negative side electrodes are made from an alloy substantially comprising nickel, iron and cobalt. The adhesive layer of the first aspect of the invention is omitted from the second aspect of the invention.

Optionally, the positive and negative side electrodes are soldered to the stack. Preferably, the stack has a positive face carrying a metallization layer on which the positive side electrode is carried and a negative face carrying a metallization layer on which the negative side electrode is carried.

Preferred and/or optional features of the first aspect of the invention may be incorporated alone, or in appropriate combination, within the second aspect of the invention also, with the exception of those features relating to the adhesive which is absent in the second aspect of the invention.

### Description of Drawings

The invention will now be described, by way of example only, with reference to the accompanying drawings in which:
Figure 1 is a sectional drawing of a piezoelectric actuator according to one embodiment of the present invention;
Figure 2 is a sectional drawing of the piezoelectric actuator in Figure 1, mounted in a fuel injector body;
Figure 3 is an exploded drawing of a side electrode and a piezoelectric stack of the piezoelectric actuator in Figures 1 and 2 to illustrate a construction method; and
Figure 4 is an exploded drawing of a side electrode and a piezoelectric stack of the piezoelectric actuator in Figures 1 and 2 to illustrate an alternative construction method.

### Detailed Description of the Invention

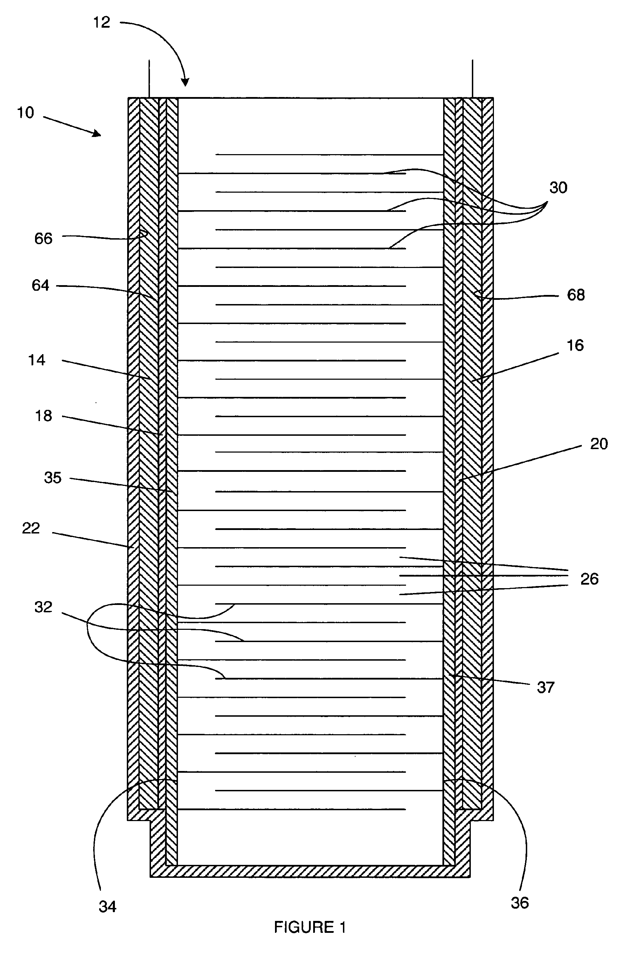

Referring to Figure 1, there is provided a piezoelectric actuator 10 including a piezoelectric stack 12, a positive side electrode 14, a negative side electrode 16, adhesive layers 18, 20 and an encapsulation means in the form of an encapsulation material 22.

The piezoelectric stack 12 comprises a plurality of piezoelectric layers or elements 26, each layer 26 being substantially separated from each adjacent layer by internal electrodes. The internal electrodes comprise a positive group 30 and a negative group 32, the electrodes of the positive group 30 being interdigitated with those of the negative group 32. The positive and negative internal electrodes 30, 32 define therebetween active regions of the piezoelectric material, which are responsive to a voltage applied across the positive and negative internal electrodes 30, 32, in use.

Each internal electrode of the positive group 30 terminates at a positive face 34 of the stack, and each internal electrode of the negative group 32 terminates at a negative face 36 of the stack. The stack additionally includes a metallization layer 35, 37 on each of the positive and negative faces 34, 36, respectively. Each of the metallization layers 35, 37 is in electrical connection with the internal electrodes of a respective group 30, 32.

The metallization layer 35 in contact with the internal electrodes of the positive group 30 carries, and so is in electrical connection with, the positive side electrode 14, and the metallization layer 37 in contact with the internal electrodes of the negative group 32 carries, and so is in electrical connection with, the negative side electrode 16. When the actuator is assembled, the positive and negative side electrodes are connected with a connector module (not shown in Figure 1). The positive side electrode 14 is in electrical connection with a positive terminal conductor of the connector module and, likewise, the negative side electrode 16 is in electrical connection with a negative terminal conductor of the connector module. Both side electrodes 14, 16 are made from a metallic material.

Adhesive layers 18, 20 are provided between the side electrodes 14, 16 and the respective metallization layers 35, 37 of the piezoelectric stack 12. The adhesive layers 18, 20 are made from an electrically conductive adhesive material.

The stiffness of the adhesive layers 18, 20 is much smaller than that of the piezoelectric stack 12 or the side electrodes 14, 16. As a result, the adhesive layers 18, 20 are compliant with respect to the stack 12 and the side electrodes 14, 16. Such an arrangement is advantageous in that, if the side electrodes 14, 16 have a different coefficient of thermal expansion to the piezoelectric stack 12, the differential strains which arise between the stack 12 and the side electrodes 14, 16 upon a change in temperature can be substantially accommodated by elastic deformation of the adhesive layers 18, 20. Electrical contact between the side electrodes 14, 16 and the internal electrodes 30, 32 is maintained through the respective adhesive layers 18, 20 and metallization layers 35, 37. The stresses that would arise in the absence of the compliant adhesive layers 18, 20 are thus avoided, improving the reliability of the actuator.

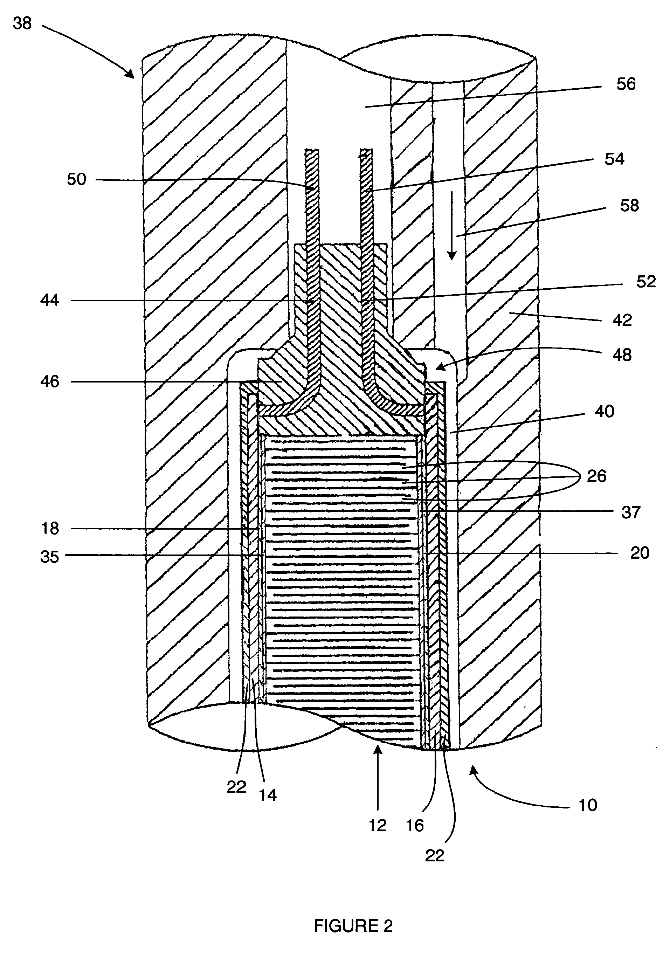

Figure 2 shows an actuator of the present invention disposed within a fuel injector 38 of a known type. An example of such a fuel injector can be found, for example, in the Applicant's European Patent No. 0 995 901. The actuator 10 is contained within a void 40 in an injector body 42. The positive terminal conductor 44, which connects with the positive side electrode 14, extends through a ceramic body 46 of the connector module 48 and terminates in a positive terminal blade 50. Similarly, the negative terminal conductor 52, which connects with the negative side electrode 16, extends through the connector module body 46 and terminates in a negative terminal blade 54. The terminal conductors 44, 52 are connected to the respective positive and negative side electrodes 14, 16. The terminal blades 50, 54 are accessible for connection to a power source (not shown) under external control via a drilling 56 into the void 40.

The void 40 communicates with a fuel supply line 58 through which fuel at high pressure is supplied to the void 40. The void 40 forms a part of the flow path for fuel. The fuel pressure in the void 40 varies cyclically between typically 200 to 2000 bar while the fuel system is pressurised and injection events are occurring. The encapsulation material 22 is a polymeric material which covers the side electrodes 14, 16, adhesive layers 18, 20 and piezoelectric stack 12. The encapsulation material 22 prevents detrimental fuel ingress into the piezoelectric stack 12.

The actuator of the present invention is particularly suited to application in an injector of the type shown in Figure 2, since the high hydrostatic fuel pressure acting on the actuator 10 acts to push the side electrodes 14, 16 towards the adhesive layers 18, 20 and the piezoelectric stack 12. These forces help to maintain good electrical contact between each of the side electrodes 14, 16 and the ends of the respective group of internal electrodes 30, 32.

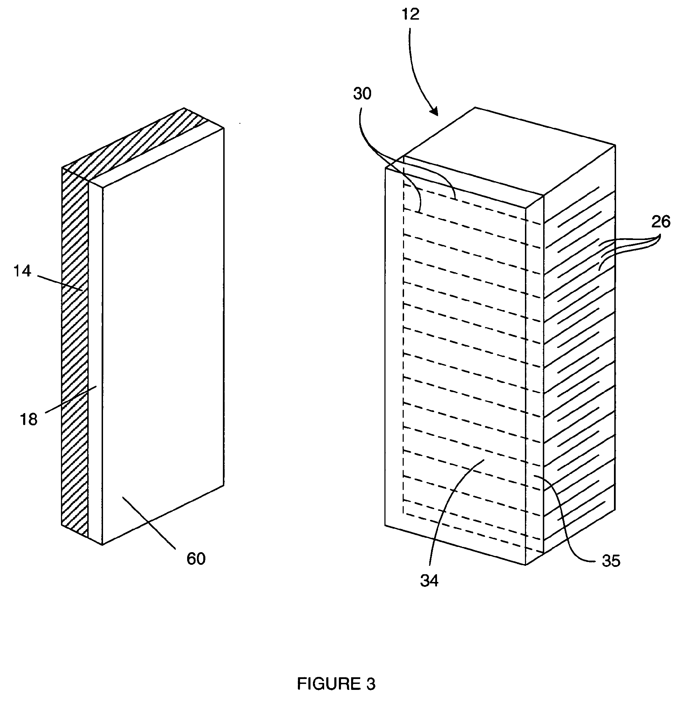

Figure 3 illustrates a preferred method of constructing the actuator of the present invention in which, advantageously, the adhesive layer 18 is applied to an inner surface 64 of a side electrode 14 before attachment of the side electrode to the piezoelectric stack 12. The application of the side electrode 14 to the stack 12 could be achieved by first providing a backing layer (not shown) upon which the adhesive layer 18 is carried, and then sticking the first exposed surface of the adhesive layer 18 to the side electrode 14. The backing layer is then removed and, finally, the newly exposed surface 60 of the adhesive layer 18 is pressed to the metallization layer 35 of the piezoelectric stack 12. Such a process allows the side electrodes 14, 16 to be conveniently attached to the piezoelectric stack 12 during manufacture but avoids the requirement for heat treatment or soldering as in known techniques. Conveniently, the side electrodes 14, 16 could be supplied and stored ready-assembled with the adhesive layer 18 and the backing layer.

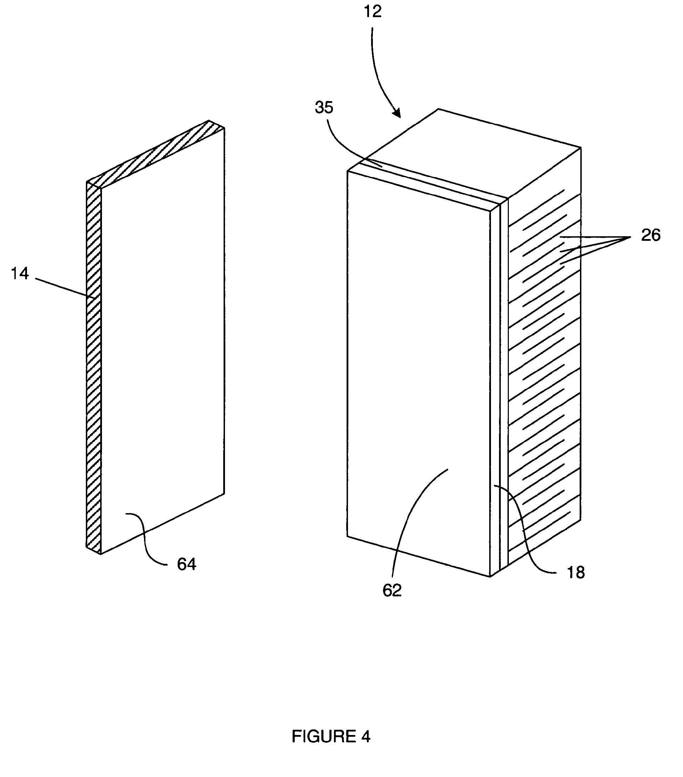

Figure 4 illustrates an alternative method of forming the actuator of the present invention, in which the adhesive layer 18 is applied first to the piezoelectric stack 12, for example by a dispensing roller, and the side electrode 14 is subsequently pressed on to the exposed surface 62 of the adhesive layer 18.

One particular advantage of the present invention is that the side electrode material need not be restricted to metals with a coefficient of expansion close to that of the piezoelectric material of the stack. For example, a currently preferred material for the side electrodes is an alloy having nickel, iron and cobalt as its major constituents. A suitable such alloy is Incoloy 909 (Incoloy is a registered trade mark of Huntington Alloys Canada Ltd.). Incoloy 909 has better mechanical properties than Invar, and is therefore more resistant to failure. For example, the tensile strength of Incoloy 909 is greater than 1000 MPa. Incoloy 909 has a coefficient of thermal expansion of around 8 x 10⁻⁶ K⁻¹, which is several times larger than the coefficient of thermal expansion of Invar. The provision of the compliant adhesive layer facilitates the use of such side electrode materials with relatively large coefficients of thermal expansion, but whose other physical and mechanical properties offer advantages over those materials with smaller coefficients of thermal expansion.

Preferably, the stiffness of the side electrodes 14, 16 is as low as possible, in order to reduce any stresses that might arise due to thermal strains or extension of the stack 12. Ideally, the thickness of each side electrode 14, 16 should be approximately 0.1 mm, although thicker side electrodes could be employed. The width of each side electrode 14, 16 is preferably less than 3 mm. However, the side electrodes 14, 16 could have any convenient size and shape, and need not have the same area as the respective surface 34, 36 of the stack 12.

Preferably, the side electrodes 14, 16 have smooth outer surfaces 66, 68 without holes or protrusions. Such a shape avoids locations with high stress concentrations and potential for damage to the polymer encapsulation 22 under the influence of the hydrostatic fuel pressure. In an alternative embodiment, the encapsulation may be omitted.

The side electrodes 14, 16 are preferably welded to the terminal conductors 44, 52. Alternatively, the connection between the side electrodes 14, 16 and the terminal conductors 44, 52 could be achieved by any suitable method, such as soldering.

To avoid contamination of the piezoelectric material, the adhesive layers 18, 20 are preferably made from a silver-free polymer-based adhesive with good electrical conductivity, such as 3M Electrically Conductive Tape 9713 (3M is a registered trade mark of 3M Company).

It will be appreciated that the actuator of the present invention could be used in fuel injectors with different designs. For example, the connector module 48 previously described could be replaced with a connector module of alternative construction, such as that known from the Applicant's co-pending European Patent Application No. 1 596 058. Also, the actuator need not be immersed in a volume of fuel to exert hydrostatic loading but may be formed in a volume of other fluid. Furthermore, the actuator 10 could be utilised in other applications, for example in liquid pumps.

## Claims

1. A piezoelectric actuator comprising:
a stack (12) of piezoelectric elements (26) formed from a piezoelectric material,
a plurality of positive internal electrodes (30) interdigitated with a plurality of negative internal electrodes (32) throughout the stack (12) to define active regions of the piezoelectric material which are responsive to a voltage applied across the positive and negative internal electrodes (30, 32) in use,
a positive side electrode (14) for connection with the positive internal electrodes (30) and
a negative side electrode (16) for connection with the negative internal electrodes (32),
**characterised in that** the positive and negative side electrodes (14, 16) are formed from a metal and are attached to the stack (12) by an electrically conductive adhesive (18, 20).

2. The piezoelectric actuator as claimed in claim 1, wherein the electrically conductive adhesive forms a compliant layer of adhesive (18) between the positive side electrode (14) and the stack (12) and a compliant layer of adhesive (20) between the negative side electrode (16) and the stack (12).

3. The piezoelectric actuator as claimed in claim 2, wherein the stack (12) has a positive face (34) carrying a metallization layer (35) on which the positive side electrode (14) is carried and a negative face (36) carrying a metallization layer (37) on which the negative side electrode (16) is carried, so that each adhesive layer (18, 20) is sandwiched between one of the metallization layers (35, 37) and the respective positive or negative side electrode (14, 16).

4. The piezoelectric actuator as claimed in any one of claims 1 to 3, wherein the electrically conductive adhesive (18, 20) is capable of elastic deformation so as to accommodate differential strains arising between the stack (12) and the positive and negative side electrodes (14, 16).

5. The piezoelectric actuator as claimed in any one of claims 1 to 4, further comprising an outer encapsulation means (22).

6. The piezoelectric actuator as claimed in claim 5, wherein the positive and negative side electrodes (14, 16) are formed with a smooth outer surface (66, 68) for contact with the outer encapsulation means (22).

7. The piezoelectric actuator as claimed in any one of claims 1 to 6, wherein the positive and negative side electrodes (14, 16) are formed from an alloy substantially comprising nickel, iron and cobalt.

8. The piezoelectric actuator as claimed in any one of claims 1 to 7, further comprising a connector module (48) for supplying the voltage across the positive and negative side electrodes (14, 16) when connected with an external voltage supply, in use.

9. A fuel injector for use in an internal combustion engine, the fuel injector including:
a fluid volume (40) for receiving fluid,
a piezoelectric actuator as claimed in any one of claims 1 to 8, wherein the piezoelectric actuator is housed within the fluid volume (40) so that a hydrostatic load is applied by the fluid to the piezoelectric stack (12).

10. The fuel injector as claimed in claim 9, wherein the fluid volume is a volume for receiving fuel.

11. The fuel injector as claimed in claim 10, wherein the fluid volume forms a part of the flow route for fuel between an injector inlet and an injector outlet to the engine.

12. A method of forming a piezoelectric actuator comprising a stack (12) of piezoelectric elements (26) formed from a piezoelectric material, a positive side electrode (14) for connection with a plurality of positive internal electrodes (30) and a negative side electrode (16) for connection with a plurality of negative internal electrodes (32), the method comprising:
providing an adhesive layer (18, 20) comprising a first surface which is exposed and a second surface which is adhered to the one of the positive and negative side electrodes (14, 16), and
applying the exposed, first surface of the adhesive layer (18, 20) to the piezoelectric stack (12).

13. The method as claimed in claim 12, wherein the first surface of the adhesive layer (18, 20) is exposed by removal of a backing layer.

14. The method as claimed in claim 13, wherein the backing layer is applied to the first surface of the adhesive layer (18, 20) after the second surface of the adhesive layer (18, 20) has been adhered to one of the positive and negative side electrodes (14, 16).

15. The method as claimed in claim 13, wherein the backing layer is applied to the first surface of the adhesive layer (18, 20) before the second surface of the adhesive layer (18,20) has been adhered to one of the positive and negative side electrodes (14, 16).

16. A method of forming a piezoelectric actuator comprising a stack (12) of piezoelectric elements (26) formed from a piezoelectric material, a positive side electrode (14) for connection with a plurality of positive internal electrodes (30) and a negative side electrode (16) for connection with a plurality of negative internal electrodes (32), the method comprising:
providing an adhesive layer (18, 20) comprising a first surface which is exposed and a second surface which is adhered to the piezoelectric stack (12), and
applying the exposed, first surface of the adhesive layer (18, 20) to one of the positive and negative side electrodes (14, 16).

17. The method as claimed in claim 16, wherein the first surface of the adhesive layer (18 ,20) is exposed by removal of a backing layer.

18. The method as claimed in claim 17, wherein the backing layer is first applied to the first surface of the adhesive layer (18, 20) when the second surface of the adhesive layer (18, 20) is adhered to the piezoelectric stack (12).

19. The method as claimed in claim 17, wherein the backing layer is provided on the first surface of the adhesive layer (18, 20) before the second surface of the adhesive layer (18, 20) is adhered to the piezoelectric stack (12).

20. A piezoelectric actuator comprising:
a stack (12) of piezoelectric elements (26) formed from a piezoelectric material,
a plurality of positive internal electrodes (30) interdigitated with a plurality of negative internal electrodes (32) throughout the stack (12) to define active regions of the piezoelectric material which are responsive to a voltage applied across the positive and negative internal electrodes (30, 32) in use,
a positive side electrode (14) for connection with the positive internal electrodes (30) and
a negative side electrode (16) for connection with the negative internal electrodes (32),
**characterised in that** the positive and negative side electrodes (14, 16) are made from an alloy substantially comprising nickel, iron and cobalt.

21. The piezoelectric actuator as claimed in claim 20, wherein the positive and negative side electrodes (14, 16) are soldered to the stack (12).

22. The piezoelectric actuator as claimed in claim 20 or claim 21, wherein the stack (12) has a positive face (34) carrying a metallization layer (35) on which the positive side electrode (14) is carried and a negative face (36) carrying a metallization layer (37) on which the negative side electrode (16) is carried.
